# EUROPÄISCHE PATENTSCHRIFT

(11) **EP 3 111 528 B1**
(45) Veröffentlichungstag und Bekanntmachung des Hinweises auf die Patenterteilung: **03.01.2018**
(21) Anmeldenummer: 15703476.0
(22) Anmeldetag: 21.01.2015
(51) Int. Cl.: H02J 3/16, H02J 3/18, G01R 19/165

(54) **VERFAHREN ZUR VERMEIDUNG VON SPANNUNGSBANDVERLETZUNGEN**
METHOD FOR PREVENTING VOLTAGE RANGE DEVIATIONS
PROCEDE PERMETTANT D'EVITER LES VIOLATIONS DE PLAGES DE TENSION

(30) Priorität: 27.02.2014 AT 501482014
(43) Veröffentlichungstag der Anmeldung: 04.01.2017
(73) Patentinhaber: Siemens AG Österreich, 1210 Wien (AT)
(72) Erfinder: SCHWALBE, Roman, A-1100 Wien (AT); EINFALT, Alfred, A-1210 Wien (AT); BLETTERIE, Benoit, A-1210 Wien (AT); TREMMEL, Werner, A-2020 Hollabrunn (AT); ZEILINGER, Franz, 1150 Wien (AT)
(74) Vertreter: Maier, Daniel Oliver
(86) Internationale Anmeldenummer: PCT/EP2015/051117
(87) Internationale Veröffentlichungsnummer: WO 2015/128119

(56) Entgegenhaltungen:
- EP-A1- 2 445 077
- WO-A2-2014/001073
- WO-A2-2014/013010
- FR-A1- 2 894 087
- US-A1- 2013 134 779

## Beschreibung

### Technisches Gebiet

Die Erfindung betrifft ein Verfahren zur Vermeidung von Spannungsbandverletzungen zumindest eines Abschnitts eines Energieverteilernetzes, welches zumindest einen Transformator mit einem Transformatorstufensteller und einer Sammelschiene sowie zumindest einen Netzknoten umfasst.

Dieses Verfahren dient somit zur Überwindung der zurzeit an den klassischen Netzbetrieb gestellten Herausforderungen der Stabilisierung von Spannungsbandverletzungen, da durch die immer stärker werdende Durchdringung mit dezentralen, meist erneuerbaren Energieerzeugungsanlagen (DEA) als auch der zunehmenden Entwicklung der Elektromobilität immer stärkere Schwankungen der Spannung auftreten. Dabei versteht man unter einer dezentralen Energieerzeugungsanlage (DEA) zum Beispiel eine Photovoltaikanlage oder eine Windkraftanlage. Das erfindungsgemäße Verfahren nutzt die Verwertung von Messdaten aus Energieverteilernetzen mit Netzknoten und stellt somit einen Teil eines robusten Netzmanagementkonzepts zur Vermeidung von Spannungsbandverletzungen dar. Zu einem robusten Netzmanagementkonzept gehören sowohl die Planung als auch der Betrieb von energietechnischen Erzeugungs- und Verbrauchseinheiten, wobei eine Spannungsbandverletzung dann vorliegt, wenn beispielsweise eine Netzknotenspannung oder eine Trafospannung außerhalb eines vordefinierten zulässigen Spannungsbereichs liegt. Dabei müssen die Ressourcenschonung als auch die Kostensenkung, bei Sicherstellung des Energiebedarfs der Nutzer, berücksichtigt werden.

### Stand der Technik

In den letzten Jahren zeigte sich der Trend zu sogenannten "Smart Grids", welche als intelligente Stromnetze die kommunikative Vernetzung und Steuerung von Stromerzeugern, Speichern, elektrischen Verbrauchern und Netzbetriebsmitteln in Energieübertragungs- und Energieverteilungsnetzen der Elektrizitätsversorgung umfassen.

Dabei kann die Netzstabilität in Energieübertragungs- und Energieverteilungsnetzen vorwiegend in zwei Problembereiche eingeteilt werden: Das vorherrschende Problem in ländlichen Energieverteilernetzen ist die Spannungserhaltung, das auch als "U-Problem" bezeichnet wird. In urbanen Energieverteilernetzen, die aufgrund der Lastdichte eher geringe Leitungslängen aufweisen, ist weniger die Spannungserhaltung als vielmehr das Problem der Auslastung von Betriebsmitteln vorherrschend. Dies wird auch als "I-Problem" bezeichnet. Dezentrale Einspeiser verringern dabei die hohe Auslastung von Leitungen und Transformatoren. In den seltensten Fällen werden aber auch die Leistungsgrenzen bei der Rückspeisung verletzt.

Darüber hinaus können z.B. in suburbanen Gebieten Netzabschnitte innerhalb eines Netzgebietes sowohl einen ländlichen als auch einen urbanen Charakter haben. Um beim letzten Teilnehmer noch die durch Normen (beispielsweise durch die EN50160) vorgegebenen Spannungsgrenzen einzuhalten bzw. die Betriebsmittel nicht zu überlasten, muss entweder Netzausbau betrieben oder ein aktives Netzmanagementsystem eingesetzt werden. Letzteres greift gezielt auf Erzeuger, flexible Verbraucher oder auch Speicher im Energieverteilernetz zu, um den Netzbetrieb normgerecht aufrecht zu erhalten.

Dabei ist die Problemstellung sowohl für Niederspannungsnetze als auch für Mittelspannungsnetze ähnlich. Neben sehr aufwändigen, modellbasierten Lösungsmöglichkeiten werden in Zukunft vor allem auch einfach zu implementierende, möglichst allgemein gültige Lösungen gefordert.

Dahingehend wurde zum Beispiel in Deutschland für Elektrizitätserzeugungsanlagen, deren Leistung 100 kW übersteigt, die sogenannte Mittelspannungsrichtlinie (Richtlinie für Anschluss und Parallelbetrieb von Erzeugungsanlagen am Mittelspannungsnetz) vorgesehen, laut welcher derartige Elektrizitätserzeugungsanlagen von sich aus zur statischen und dynamischen Netzstabilisierung beitragen müssen. Ähnliche Vorgaben könnten daher in Zukunft auch kleinere Elektrizitätserzeugungsanlagen, etwa solche in sogenannten "Smart Buildings", treffen.

Im Allgemeinen werden derzeit zur Spannungsbandeinhaltung in Mittel- und Niederspannungsnetzen kaum aktive Maßnahmen gesetzt. In Mittelspannungsnetzen werden seit wenigen Jahren den Elektrizitätserzeugungsanlagen Vorgaben oder auch spannungsbezogene Wirkleistungs- P(U) bzw. Blindleistungs-Q(U) Charakteristiken als Alternative zum Netzausbau vorgeschrieben. In Niederspannungsnetzen sind solche Maßnahmen eher noch untypisch.

Bei Transformatoren gibt es für den Umspanner (von Hochspannung HS auf Mittelspannung MS) neben der klassischen Regelung basierend auf fixen Sammelschienen noch die Möglichkeit eine Compoundierung einzusetzen. Dabei wird aufgrund des Lastflusses über den Transformator auf die Last- bzw. Einspeisesituation im Netz rückgeschlossen und basierend auf der Richtung und der Stärke des Lastflusses der Sollwert der Sammelschienenspannung beeinflusst: Geht der Lastfluss in Richtung Mittelspannung(snetz), so liegt ein Lastfall vor, daher wird es eher zu einer Verletzung der unteren Spannungsbandgrenze kommen und daher wird eine Regelung auf eine eher höhere Sammelschienenspannung erfolgen müssen. Geht der Lastfluss in Richtung Hochspannung, dann liegt eine Einspeisung aus dem Mittelspannungsnetz vor, es kommt daher eher zu einer Verletzung der oberen Grenze des Spannungsbandes, sodass Regelung auf eine eher niedrigere Sammelschienenspannung erfolgen wird. Um das Problem in einzelnen Strängen zu lösen werden zum Teil auch Längsregler eingesetzt.

Für Trafostationen zwischen dem Mittelspannungs- und Niederspannungsbereich (MS/NS) gibt es seit kurzem regelbare Transformatoren, die vorrangig Schwankungen im Mittelspannungsbereich ausregeln bzw. bei massivem Rückfluss auch die Situation im Niederspannungsbereich miteinbeziehen. Aus den Druckschriften WO 2014/01310 A2, EP 2 445 077 A1, WO 2014/001073 A2 und FR 2 894 087 A1 sind verschiedene Verfahren zur Stabilisierung der Netzspannung in einem Netzabschnitt eines Energieverteilernetzes bekannt.

### Darstellung der Erfindung

Ziel der vorliegenden Erfindung ist es, eine Lösung zur Verfügung zu stellen, welche zumindest einen Beitrag zur statischen Netzstabilisierung liefert.

Diese Aufgabe wird durch ein Verfahren mit den Merkmalen des Patentanspruchs 1 gelöst und umfasst ein Verfahren zur Vermeidung von Spannungsbandverletzungen zumindest eines Abschnitts eines Energieverteilernetzes, welches zumindest einen Transformator mit einem Transformatorstufensteller und einer Sammelschiene sowie zumindest einen Netzknoten umfasst, gekennzeichnet durch die folgenden Schritte:
1) laufende Messung zumindest eines Netzknotenspannungswerts an dem Netzknoten,
2) laufende Messung und Speicherung von Trafospannungswerten an der Sammelschiene,
3) Bildung zumindest eines Mittelwerts der gespeicherten Trafospannungswerte der Sammelschiene, vorzugsweise innerhalb eines vorgegebenen Zeitintervalls,
4) Bildung eines Differenzwerts, basierend auf dem gebildeten Mittelwert und dem gemessenen Netzknotenspannungswert an dem Netzknoten,
5) Berechnung eines Netzknotenkorrespondenzwerts, welcher zumindest näherungsweise dem aktuell an dem Netzknoten anliegenden Netzknotenspannungswert entspricht, mit Hilfe des Differenzwerts und eines gebildeten Mittelwerts und
6) laufendes Wiederholen der Schritte 2) bis 5), wobei bei Eintreffen eines weiteren an dem Netzknoten anliegenden gemessenen Netzknotenspannungswerts mit diesem der Differenzwert gebildet wird,
wobei eine Stufung des Transformatorstufenstellers durchgeführt wird, wenn der berechnete Netzknotenkorrespondenzwert außerhalb eines vorgegebenen Spannungsbandes liegt.

Somit ist der Gegenstand der vorliegenden Erfindung eine aktive Regelung, die aktuelle bzw. ansatzweise aktuelle Werte aus dem Energieverteilernetz verwendet, um zumindest die Trafostufenstellung derart zu beeinflussen, dass die Netzknotenspannungswerte innerhalb der vorgegebenen Grenzen (z.B. gemäß EN50160) in allen denkbaren Last- und Einspeisefällen gehalten werden. Dabei ist eine grundlegende Eigenschaft des erfindungsgemäßen Verfahrens, dass das Regelungskonzept den Trafospannungswert innerhalb des Spannungsbandes hält. Das heißt, dass nur dann eine Stufung des Transformatorstufenstellers aufgrund eines außerhalb des Spannungsbandes liegenden Netzknotenkorrespondenzwerts erfolgt, wenn zuvor sichergestellt ist, dass der Trafospannungswert innerhalb des Spannungsbandes liegt.

Das erfindungsgemäße Verfahren gewährleistet somit eine Nutzung der Dynamik bzw. eine hohen Aktualisierungsrate der Trafospannungswerte, um die Verwendbarkeit der Netzknotenspannungswerte mit einer niedrigen Aktualisierungsrate zu erhöhen. Dies setzt voraus, dass die Trafospannungswerte zuverlässig mit einer hohen Qualität und Regelmäßigkeit übertragen werden, während zwischen der Übertragung der Netzknotenspannungswerte längere Pausen auftreten können, weshalb das erfindungsgemäße Verfahren speziell zur Lösung des "U-Problems" vorgesehen ist.

Dabei ist dieses Verfahren speziell - aber nicht ausschließlich - für Spannungsmessungen in unvermaschten Stromnetzen anwendbar, welche über einen zentralen Transformator mit der nächsthöheren Netzebene verbunden sind. Hier breiten sich Spannungsschwankungen an der Sammelschiene, bspw. durch Spannungsschwankungen in der nächsthöheren Netzebene oder durch eine Stufung des Transformatorstufenstellers, im gesamten vom Transformator versorgten Energieverteilernetz bzw. Netzabschnitt aus. In einer ersten Näherung kann davon ausgegangen werden, dass eine solche Spannungsänderung an der Sammelschiene im gesamten Energieverteilernetz bzw. im zum Transformator zugehörigen Netzabschnitt eine Spannungsänderung gleicher Spannungshöhe bewirkt. Wegen dieser direkten Abhängigkeit der Spannungen im Energieverteilernetz untereinander kann anhand der Messwerte mit hoher Aktualisierungsrate und somit einer kurzen Mittelwertbildung laufend ein aktueller Wert für die zwischen den gemessenen Netzknotenspannungswerten, welche eine niedrige Aktualisierungsrate und eine lange Mittelwertbildung aufweisen, auftretenden Netzknotenspannungswerte zumindest näherungsweise berechnet werden.

Um dies zu bewerkstelligen, muss für die Messwerte mit hoher Aktualisierungsrate ein Trend angelegt werden, d.h. der zeitliche Verlauf der Trafospannungswerte an der Sammelschiene wird über einen längeren Zeitraum mit einer hohen Granularität gespeichert. Bei Eintreffen eines gemessenen Netzknotenspannungswerts (der ebenfalls das Ergebnis einer Mittelwertbildung sein kann, wie unten noch erläutert wird), welcher gemäß obiger Erläuterung eine - gegenüber dem Trafospannungswert - niedrigere Aktualisierungsrate aufweist, an einer Steuerung wird durch die Steuerung ein Differenzwert gebildet, basierend auf dem gebildeten Mittelwert und dem gemessenen Netzknotenspannungswert. Dieser Differenzwert wird bis zum Eintreffen eines neuen Netzknotenspannungswerts gespeichert. Dabei ist der absolut gemessene Netzknotenspannungswert für die Stufung des Transformatorstufenstellers nicht von Interesse, sondern lediglich die Differenz zum berechneten Mittelwert der Trafospannung. Durch diesen Differenzwert können anhand des Verlaufs eines Trafospannungswerts mit hoher Aktualisierungsrate immer aktuelle Werte von Netzknotenspannungswerten mit niedriger Aktualisierungsrate berechnet werden, indem der Differenzwert mit dem aktuellen Trafospannungswert addiert wird.

Erfindungsgemäß lässt sich dieses Verfahren verfeinern, indem eine Stufung des Transformatorstufenstellers basierend auf dem aktuell berechneten Netzknotenkorrespondenzwert in Abhängigkeit nachfolgender Prioritätsstufen erfolgt:
1) der Netzknotenkorrespondenzwert soll über einer Untergrenze des vorgegebenen Spannungsbandes liegen und
2) der Netzknotenkorrespondenzwert soll unter einer Obergrenze des vorgegebenen Spannungsbandes liegen,
wobei die erste Prioritätsstufe erfüllt wird, bevor die zweite Prioritätsstufe betrachtet wird.

Mit anderen Worten erfolgt eine Stufung des Transformatorstufenstellers, sobald ein aktuell berechneter Netzknotenspannungswert einen bestimmten vorgegebenen Schwellwert über- oder unterschreitet, wobei die Stufung selbst von der Stufenhöhe des Transformators abhängt. Dabei werden im Wesentlichen die Schwankungen des Mittelspannungsnetzes durch den Stufenregler ausgeglichen. In der Regel werden mehrere Netzknoten überwacht, sodass für alle berechneten Netzknotenkorrespondenzwerte verschiedener Netzknoten sichergestellt werden muss, dass alle innerhalb des vorgegebenen Spannungsbandes liegen.

Durch die vorgeschlagene Priorität wird sichergestellt, dass Unterspannungen beseitigt werden, unabhängig davon ob Überspannungen auftreten. Der Grund dafür ist, dass dezentrale Einspeiser mit einer lokalen Spannungsregelung ausgestattet sind. Auch bei Versagen dieser Regelung würde üblicherweise der Überspannungsschutz zur Trennung und somit zur Beseitigung der Überspannungssituation führen.

Im Allgemeinen gilt es auch zu berücksichtigen, dass ein Transformatorstufensteller im Mittelspannungs- oder auch Niederspannungsbereich nicht unnötig viele Stufungen vornehmen soll, da dies unter Umständen dessen Lebensdauer reduziert, wodurch hohe Kosten entstehen können.

In einer erfindungsgemäßen Ausführungsform wird bei der Übermittlung des Netzknotenspannungswerts ein Zeitstempel zur Zuordnung des gemessenen Netzknotenspannungswerts zu dem zeitlich zugehörigen gebildeten Mittelwert der gespeicherten Trafospannungswerte mitgesendet.

Dies dient dazu, die spezielle Problematik der Datenzugehörigkeit, welche sich durch die zeitliche Asynchronität der Daten ergibt, zu überwinden, da sich durch die Übermittlung der Daten bzw. deren Aufbereitung mit Hilfe der Steuerung Differenzzeiten ergeben, wodurch ansonsten gegebenenfalls falsche Zuordnungen der gemessenen Netzknotenspannungswerte zu den gebildeten Trafospannungsmittelwerten getroffen werden.

In einer weiteren erfindungsgemäßen Ausführungsform wird ein Netzknotenspannungsmittelwert aus gemessenen Netzknotenspannungswerten innerhalb eines Zeitintervalls gebildet und anstelle der gemessenen Netzknotenspannungswerte, vorzugsweise nach einer vorgegebenen Taktzeit, zur Weiterverarbeitung übermittelt. Dieser Verfahrensschritt ist in gleicher Weise auch auf die Trafospannungswerte anwendbar.

Dabei werden die notwendigen Netzknotenspannungsmittelwerte vor oder nach der Übertragung gebildet und stellen beispielsweise gleitende 5 Minutenwerte dar, wobei aus den vorhandenen Messwerten die für die Regelung des Transformators durch die Steuerung notwendigen Kennwerte, insbesondere minimale und maximale Netzknotenspannungswerte, ermittelt werden. Hierbei ist nochmals hervorzuheben, dass unterschiedlichste Zeitintervalle zur Bildung der Netzknotenspannungsmittelwerte und verschiedenste Taktzeiten zur Aktualisierung, gegebenenfalls auch asynchron, verwendet werden können, beispielsweise sekündlich übermittelte Sekundenmittelwerte von den Trafospannungswerten und minütlich übermittelte 5 Minutenwerte von den Netzknotenspannungswerten. Für den Fall, dass verschiedene Taktzeiten zur Aktualisierung verwendet werden, die Netzknotenspannungsmittelwerte also asynchron übermittelt werden, werden - gemäß Schritt 6) in Anspruch 1 - immer bei Eintreffen eines neuen Netzknotenspannungsmittelwerts die Schritte 2) bis 4) in Anspruch 1 zur Bildung eines neuen Differenzwerts durchlaufen.

Somit wird bei Eintreffen eines Netzknotenspannungswerts (bzw. eines Netzknotenspannungsmittelwerts) anhand des Zeitstempels und des Zeitintervalls zur Netzknotenspannungsmittelwertbildung ein Vergleichsmittelwert aus dem obig erläuterten Trend des entsprechenden Trafospannungswerts berechnet.

Insbesondere kann vorgesehen sein, dass zur Bildung des Differenzwerts ein Mittelwert der gespeicherten Trafospannungswerte herangezogen wird, der innerhalb des gleichen Zeitintervalls wie der Netzknotenspannungsmittelwert gebildet wird, während für die Berechnung des Netzknotenkorrespondenzwerts ein anderer Mittelwert der gespeicherten Trafospannungswerte herangezogen wird, der während eines kürzeren Zeitintervalls gebildet wird.

In einer weiteren erfindungsgemäßen Ausführungsform wird die zusätzliche Möglichkeit geboten, per Broadcast alle bzw. gegebenenfalls basierend auf diversen Kriterien bestimmten Energieerzeugungsanlagen des Energieverteilnetzes, vorzugsweise dezentrale Energieerzeugungsanlagen in Form einer Photovoltaikanlage oder aber auch einfache Wechselrichter, in die Spannungsregelung einzubinden.

Hierbei wird in einer Ausführungsform der Erfindung mit einem gemessenen maximalen Netzknotenspannungswert und einem gemessenen minimalen Netzknotenspannungswert von zumindest zwei unterschiedlichen Netzknoten oder, in einer weiteren Ausführungsform, aus den entsprechenden berechneten Netzknotenkorrespondenzwerten eine Spreizung der Netzspannung des Energieverteilernetzes berechnet. Diese ermittelte Spreizung wird verwendet, um daraus die an eine Energieerzeugungsanlage, welche an das Energieverteilnetz angeschlossen ist, zu übermittelnde Abänderung einer einzuspeisenden Blindleistung zu berechnen.

Dabei wird vorzugsweise bei Überschreitung der Spreizung über einen vorgegebenen Maximalschwellwert schrittweise zusätzliche Blindleistung der Energieerzeugungsanlage in das Energieverteilernetz eingespeist und bei Unterschreitung der Spreizung unter einen vorgegebenen Minimalschwellwert wird schrittweise weniger Blindleistung der Energieerzeugungsanlage in das Energieverteilernetz eingespeist, wobei zwischen zwei Schritten zumindest eine vorgegebene Intervalldauer liegt. Durch diese Maßnahme wird die Spreizung, also die Differenz zwischen dem maximalen Netzknotenspannungswert und dem minimalen Netzknotenspannungswert, verringert und das Einhalten der Netzknotenspannungswerte innerhalb der vorgegebenen Grenzen erleichtert.

Des Weiteren ist die Möglichkeit gegeben, per Broadcast allen bzw. gegebenenfalls basierend auf diversen Kriterien bestimmten Energieerzeugungsanlagen Kennlinien zu übermitteln. Dabei wird in Abhängigkeit der aktuell vorliegenden Netzspannungssituation immer eine geeignete, beliebig definierte Kennlinie, vorzugsweise jedoch eine Spannungs-Wirk- und -Blindleistungs-Kennlinie, ermittelt.

In einer erfindungsgemäßen Ausführungsform wird bei Überschreitung der Spreizung über den vorgegebenen Maximalschwellwert eine Spannungs-Wirk- und -Blindleistungs-Kennlinie für eine Energieerzeugungsanlage schrittweise enger gestellt und bei Unterschreitung der Spreizung unter den vorgegebenen Minimalschwellwert wird die Spannungs-Wirk- und -Blindleistungs-Kennlinie für die Energieerzeugungsanlage schrittweise weiter gestellt, wobei eine neu gebildete Spannungs-Wirk- und -Blindleistungs-Kennlinie an die Energieerzeugungsanlage übertragen wird und solange eine schrittweise Anpassung der Spreizung an die vorgegebenen Schwellwerte erfolgt, bis dass die Spreizung innerhalb der Schwellwerte liegt.

Diese schrittweise Verstellung der Spannungs-Wirk- und -Blindleistungs-Kennlinie und deren laufende Aktualisierung ist notwendig, da es ohne einer detaillierten Information sehr schwierig ist, die optimale bzw. kleinste Verschiebung der Kennlinie zu finden. Darüber hinaus soll das erfindungsgemäße Verfahren auch so weit wie möglich unabhängig von dem zu regelnden Energieverteilernetz sein.

Mit anderen Worten soll bei einer großen Spreizung die Wechselrichterkennlinie der Energieerzeugungsanlage so eingestellt werden, dass die Blindleistung des Wechselrichters die Spreizung reduziert, d.h. hohe Spannungen sollen abgesenkt und niedrige Spannungen sollen angehoben werden bzw. gleich bleiben. Hingegen soll bei einer niedrigen Spreizung die Wechselrichterkennlinie so eingestellt werden, dass der/die Wechselrichter möglichst wenig Blindleistung einspeist/einspeisen, sodass Leitungsströme und in weiterer Folge Netzverluste klein gehalten werden.

Die neu ermittelten Kennlinienpunkte werden per Broadcast beispielsweise an zumindest einen Wechselrichter übermittelt, wobei durch Nachführung der aktuellen Kennlinie immer ein Abbild der aktuell aktiven Wechselrichtereinstellungen gegeben ist. Dadurch ist sichergestellt, dass die implizierte Erkennung ungünstiger Betriebsweisen auch den geänderten Kennlinien folgt. Dabei können als Entscheidungsgrundlage, wie die Wechselrichterkennlinie eingestellt werden soll, beliebige Parameter und nicht nur die Spreizung, welche sich aus dem gemessenen maximalen Netzknotenspannungswert und dem gemessenen minimalen Netzknotenspannungswert ergibt, verwendet werden.

Dabei wird in einer bevorzugten Ausführungsform der Erfindung nach der Übertragung der neu gebildeten Spannungs-Wirk- und -Blindleistungs-Kennlinie zumindest das Zeitintervall zur Bildung des Netzknotenspannungsmittelwerts abgewartet, bis eine weitere Spannungs-Wirk- und -Blindleistungs-Kennlinie übertragen wird. Dies gewährleistet, dass eine ansonsten gegebenenfalls auftretende sprunghafte Änderung der Kennlinie unterbleibt.

In einer weiteren erfindungsgemäßen Ausführungsform wird eine Abweichung des Spannungswerts vom Spannungsband solange mit einem Summenwert summiert, bis eine vorgegebene Summenkonstante erreicht wird, woraufhin eine Stufung des Transformatorstufenstellers durchgeführt und der Summenwert auf Null zurückgesetzt wird. Dies kann sowohl für die Trafospannungswerte als auch für die Netzknotenspannungswerte oder Netzknotenkorrespondenzwerte durchgeführt werden.

Dabei handelt es sich um eine inverse Zeitcharakteristik, welche eine Stufung des Transformatorstufenstellers sofort ausführt, wenn der Istwert sehr stark vom Toleranzbereich abweicht, aber eine Stufung verzögert, wenn der Istwert nur leicht von dem Toleranzbereich abweicht. Die Parameter dieser Regelung sind ein durch das Spannungsband vorgegebener Toleranzbereich und eine Summenkonstante, das ist jener Wert, ab dem eine Stufung durchgeführt wird.

Durch die Unabhängigkeit vom Netzmodell wird durch das erfindungsgemäße Verfahren ein sehr robustes Konzept zur Vermeidung von Spannungsbandverletzungen geschaffen. Darüber hinaus kann zum einen flexibel auf unterschiedlich vorbehandelte Netzknotenspannungswerte aus dem Energieverteilernetz reagiert und zum anderen können trotzdem rasch größere Änderungen innerhalb des Energieverteilernetzes ausgeglichen werden.

Das erfindungsgemäße Verfahren wird in der Regel rechnergestützt durchgeführt werden. Entsprechend kann die gegenständliche Erfindung auch als Computerprogrammprodukt realisiert werden, welches ein Programm umfasst und direkt in einen Speicher eines zentralen Rechners eines Energieverteilernetzes (welches über entsprechende Messgeräte zur Erfassung der benötigten Messwerte verfügt) ladbar ist, mit Programm-Mitteln, um alle Schritte des erfindungsgemäßen Verfahrens nach einem der Ansprüche auszuführen, wenn das Programm vom zentralen Rechner ausgeführt wird.

### Kurzbeschreibung der Figuren

Zur weiteren Erläuterung der Erfindung wird im nachfolgenden Teil der Beschreibung auf die Figuren Bezug genommen, aus denen weitere vorteilhafte Ausgestaltungen, Einzelheiten und Weiterbildungen der Erfindung zu entnehmen sind. Dabei zeigen:
- Fig. 1: eine schematische Darstellung der Behandlung der Netzknotenspannungen und Spannungsgrenzen in einem Ortsnetz nach dem Stand der Technik;
- Fig. 2: eine schematische Darstellung eines Energieverteilernetzes, dessen erfindungsgemäße Regelung auf Netzknotenspannungswerten und an einer Sammelschiene anliegenden Trafospannungswerten basiert;
- Fig. 3: einen Verfahrensschritt zur Bildung eines Differenzwerts;

- Fig. 4: eine schematische Darstellung einer Nachführung einer aktuell aktiven Wechselrichtereinstellung;
- Fig. 5: eine schematische Darstellung einer Spannungs-Wirk- und -Blindleistungs-Kennlinie, welche schrittweise enger gestellt wird; und
- Fig. 6: eine inverse Zeitcharakteristik.

### Ausführung der Erfindung

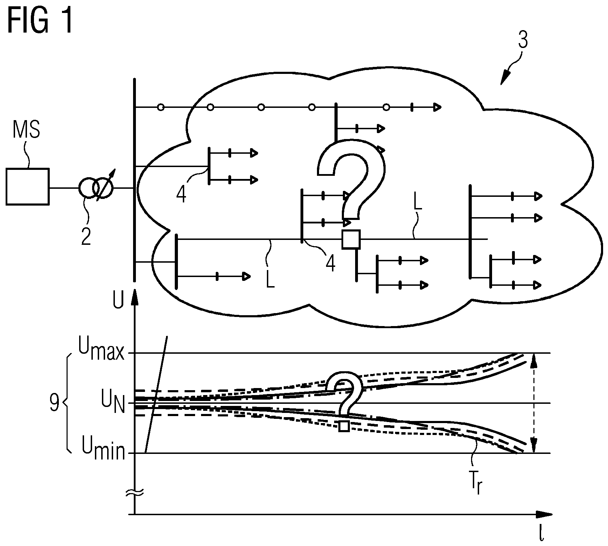

Fig. 1 zeigt eine schematische Darstellung eines im Wesentlichen unbekannten Spannungsfalls in einem Ortsnetz bzw. Energieverteilernetz 3, bei dem die Spannung U eines Stranges im Energieverteilernetz 3 über die Stranglänge l aufgetragen ist, siehe die grauen Linien. Die Verhältnisse der Spannungen im Energieverteilernetz 3 werden hauptsächlich durch die Spannungsabfälle der Versorgungsleitungen L bestimmt, welche wiederum durch die Impedanz der Leitungen verursacht werden. Da sich die Impedanz tendenziell immer erhöht, je weiter man sich im Strang vom Transformator 2 entfernt, ergibt sich tendenziell das Bild eines Trichters Tᵣ, der in den folgenden Ausführungen den unbekannten Spannungsfall innerhalb des Energieverteilernetz 3 symbolisiert und in Fig. 1 strichliert dargestellt ist. Beispielsweise sinkt im reinen Lastfall die Spannung der Netzknoten 4 durch die Spannungsabfälle durch die steigende Impedanz, je weiter sich der Netzknoten 4 vom versorgenden Transformator 2 befindet. Da an dem Transformator 2 mehrere Stränge angeschlossen sind und jeder Strang unterschiedliche Charakteristiken sowie unterschiedliche Spannungswerte aufweist, wird die untere Begrenzung des Trichters Tᵣ durch den Strang mit den niedrigsten Spannungen vorgegeben. Im Falle einer Einspeisung ändern sich die Verhältnisse und es kommt zu einer Erhöhung der Spannung.

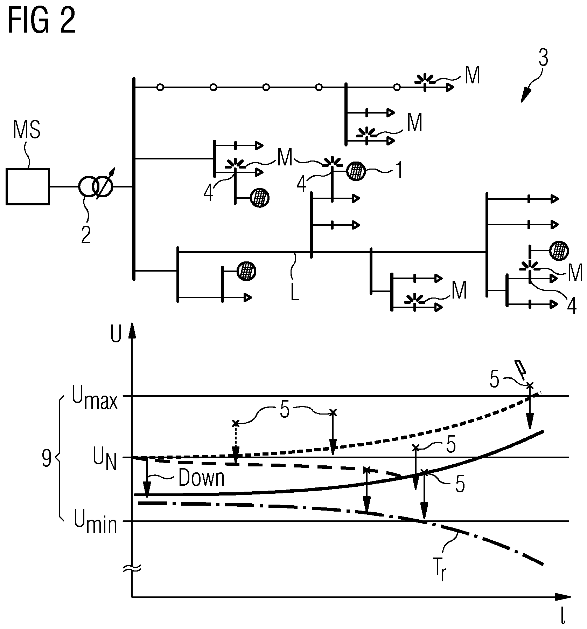

Bei Nichtkenntnis der genauen Impedanz-, Last und Einspeiseverhältnisse nimmt die Unsicherheit in Bezug auf die Spannungsverhältnisse im Netz mit der Länge l der Stränge zu, was durch die Fläche des Trichters Tᵣ dargestellt wird. Die wirklichen Netzknotenspannungswerte 5 sollten sich dadurch innerhalb dieser Fläche befinden, können sich aber auch außerhalb befinden (siehe Fig. 2). Bei der Netzplanung wurde bisher mit Hilfe konservativer Abschätzungen ("Worst Case" Abschätzung) basierend auf Näherungsformeln oder Erfahrungswerten die Form des Trichters Tᵣ durch den Netzbetreiber grob abgeschätzt, wobei die Netzknotenspannungswerte 5 mit den ungünstigsten Verhältnissen herangezogen wurden. Dabei wurde durch entsprechende Netzausbauten dafür gesorgt, dass alle Netzknotenspannungswerte 5 für alle Last- und Einspeisefälle innerhalb der Grenzen des Spannungsbandes 9 liegen.

Durch die Verwendung eines regelbaren Transformators 2 wird erreicht, dass auf der Seite des Energieverteilernetzes 3 die Sollspannung U_{N} an der Sammelschiene eingehalten wird, d.h. dass etwaige Schwankungen im übergeordneten MS-Netz ausgeglichen werden. Dadurch ist es leichter, dass sich der durch den Trichter Tᵣ dargestellte Bereich der Unsicherheit der Netzknotenspannungswerte 5 innerhalb eines durch eine minimale Spannungsgrenze Uₘᵢₙ und eine maximale Spannungsgrenze Uₘₐₓ vorgegebenen Spannungsbandes 9 befindet, dies ist durch die Pfeile für die Stufung in Fig. 2 angedeutet.

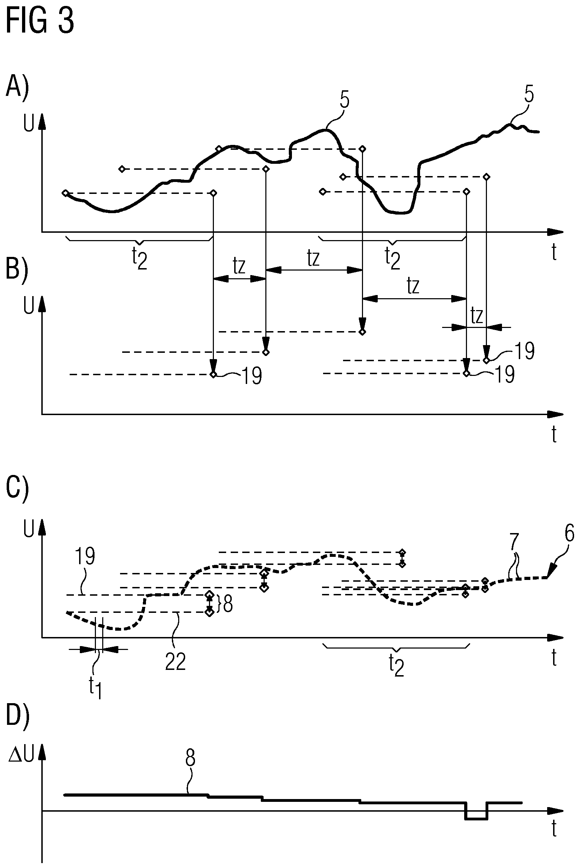

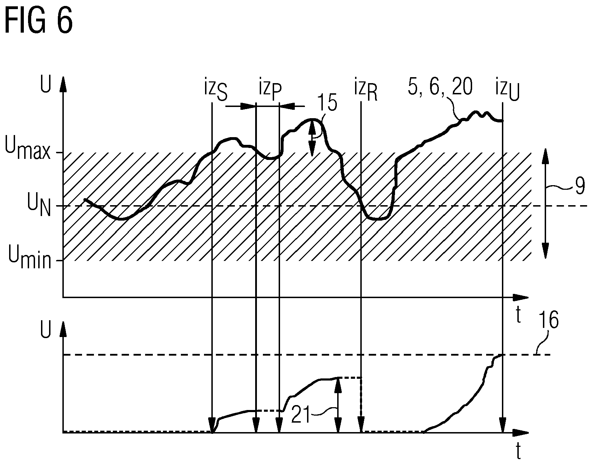

Fig. 2 zeigt eine schematische Darstellung eines Energieverteilernetzes 3, dessen Regelung auf Netzknotenspannungswerten 5, welche durch geeignete Messeinrichtungen M ermittelt werden, und den an der Sammelschiene des Transformators 2 anliegenden Trafospannungswerten 6 (siehe Fig. 3 und Fig. 6) basiert. Die in Fig. 2 dargestellten und mit einem M gekennzeichneten Kreise stellen Messeinrichtungen M dar, mit deren Hilfe der jeweilige Netzknotenspannungswert 5 ermittelt wird. Dabei ist ersichtlich, dass nicht von jedem Netzknoten 4 der Netzknotenspannungswert 5 gemessen wird. Die Netzknotenspannungswerte 5 erlauben daher ein besseres Bild bezüglich der Spannungsverhältnisse innerhalb des Energieverteilernetzes 3 als die vorhergehende Abschätzung, symbolisiert durch den Trichter Tᵣ.

In einer ersten Näherung wird davon ausgegangen, dass eine Spannungsänderung 15 (Abweichung der Spannungswerte 5, 6; siehe Fig. 6) an der Sammelschiene im gesamten Energieverteilernetz 3 eine Spannungsänderung gleicher Spannungshöhe bewirkt. In dem unterhalb dargestellten Spannungsverlauf eines Strangs über die Stranglänge l stellen die im Energieverteilernetz 3 gemessenen Netzknotenspannungswerte 5 Kreuze dar (die sich jeweils genau unter der zugeordneten Messeinrichtung M befinden), wobei deutlich ersichtlich ist, dass der an dem am weitesten vom Transformator 2 entfernten Netzknoten 4 anliegende und durch einen Blitz gekennzeichnete Netzknotenspannungswert 5 über der maximalen Spannungsgrenze Uₘₐₓ liegt, wodurch eine Stufung durch den Transformatorstufensteller nach unten, sprich zur Senkung der Netzknotenspannungswerte 5, durchgeführt werden muss. Dies bewirkt aber auch eine Absenkung sämtlicher Netzknotenspannungswerte 5 im Energieverteilernetz 3. Der Einfluss der Absenkung auf alle Netzknotenspannungswerte 5 ist durch Pfeile dargestellt. Erst durch die Kenntnis der Netzknotenspannungswerte 5 ist diese Vorgehensweise möglich, da die Spannungsgrenzen des Spannungsbandes 9 nicht verletzt werden. Würde nur die vorherige Abschätzung mittels Spannungstrichter Tᵣ verwendet werden, würde die beschriebene Stufung nicht durchgeführt und die Spannungsgrenze verletzt werden. Der durch die Stufung verschobene Spannungstrichter Tᵣ ist in Fig. 2 mit durchgezogenen Linien dargestellt, der Spannungstrichter vor der Abstufung ist strichliert dargestellt.

Fig. 3 zeigt das erfindungsgemäße Verfahren, welches basierend auf einem gebildeten Mittelwert 7 aus den gespeicherten Trafospannungswerten 6 (Fig. 3c) und einem gemessenen Netzknotenspannungswert 5 einen Differenzwert 8 bildet. Dabei berücksichtigt das erfindungsgemäße Verfahren die Dynamik der Spannungen im Energieverteilernetz 3, wobei die Messwerte mit einer hohen Aktualisierungsrate (Trafospannungswerte 6) genutzt werden, um die Messwerte mit einer niedrigen Aktualisierungsrate (Netzknotenspannungswerte 5) zu bestimmen, wodurch keine zeitintensiven Messungen an den Netzknoten 4 laufend durchgeführt werden müssen. Aufgrund der hohen Aktualisierungsrate weisen die Trafospannungswerte 6 eine kurze Dauer zur Bildung des Mittelwerts 7 auf, während die Netzknotenspannungswerte 5 aufgrund der niedrigen Aktualisierungsrate eine lange Dauer zur Mittelwertbildung aufweisen.

Im Detail sind in Fig. 3 vier Spannungsverläufe (3a - 3d) in Abhängigkeit der Zeit t dargestellt. In 3a ist als durchgehende Kurve der Verlauf der tatsächlichen Netzknotenspannungswerte 5 eines bestimmten gemessenen Netzknotens 4 dargestellt. Dabei stellen die waagrecht strichlierten Linien das Zeitintervall t₂ zur fortlaufenden Messung und Speicherung der Netzknotenspannungswerte 5 sowie zur anschließenden Bildung eines Netzknotenspannungsmittelwerts 19 dar. Dies stellt eine bevorzugte Ausführungsform dar, da die Netzknotenspannungswerte 5 auch direkt übertragen werden können. Die gebildeten Netzknotenspannungsmittelwerte 19 werden im Anschluss, dargestellt durch die langen senkrechten Pfeile von 3a auf 3b, an den Transformator 2 bzw. eine Steuerung übertragen und zur Bildung eines Differenzwerts 8 verwendet. Im Gegensatz dazu ist in 3c der Verlauf der Trafospannungswerte 6, wie dieser der Steuerung bekannt ist, als punktierte Kurve dargestellt. Konkret stellt die punktierte Kurve Mittelwerte 7 der gespeicherten Trafospannungswerte 6, vorzugsweise innerhalb des Zeitintervalls t₁, dar. Dies stellt eine bevorzugte Ausführungsform dar, da die Trafospannungswerte 6 auch direkt ohne Mittelwertbildung verwendet werden können. Die Steuerung berechnet basierend auf den übermittelten Netzknotenspannungsmittelwerten 19 und den Mittelwerten 22 (Mittelwerte aus den Trafospannungswerten 6 über die Zeit t₂) die Differenzwerte 8 (dargestellt durch die kurzen senkrechten Pfeile in 3c), deren Verlauf in 3d dargestellt ist. Entsprechend diesem Verlauf der Differenzwerte 8 entscheidet die Steuerung, ob eine Stufung durch den Transformatorstufensteller durchgeführt werden soll oder nicht. Es ist wichtig für die Konsistenz der Daten, dass für die Differenzbildung nach Fig. 3c die Mittelwertbildung sowohl für die Netzknotenspannungswerte 5 als auch für die Trafospannung 6 (Spannung der Sammelschiene) jeweils über den gleichen Zeitraum t₂ erfolgt. Für die weiteren Verfahren wird dann für die Trafospannung 6 der andere, schnellere Mittelwert 7 herangezogen, der über eine Zeit t₁ erfolgt, wobei t₂ > t₁ gilt.

Durch die direkte Abhängigkeit der Spannungen im Energieverteilernetz 3 untereinander kann anhand der Trafospannungswerte 6 mit hoher Aktualisierungsrate und somit einer kurzen Dauer zur Bildung des Mittelwerts 7 laufend ein aktueller Wert für die zwischen den gemessenen Netzknotenspannungswerten 5, welche eine niedrige Aktualisierungsrate und somit eine lange Dauer zur Bildung des Netzknotenspannungsmittelwerts 19 aufweisen, auftretenden Netzknotenkorrespondenzwerte 20 mit Hilfe des Differenzwerts 8 durch Addition des gebildeten Mittelwerts 7 mit dem Differenzwert 8 berechnet werden.

Zusammenfassend werden folgende Schritte für zumindest einen Netzknoten 4 (in der Regel erfolgt dies für alle vermessenen Netzknoten) durchgeführt:
1) laufende Messung zumindest des Netzknotenspannungswerts 5 an dem Netzknoten 4 bzw. Ermittlung des Mittelwerts 19 der Netzknotenspannungswerte 5 im vorgegebenen Zeitintervall t₂,
2) laufende Messung und Speicherung von Trafospannungswerten 6 an der Sammelschiene,
3) Bildung des Mittelwerts 7 der gespeicherten Trafospannungswerte 6 der Sammelschiene innerhalb eines vorgegebenen Zeitintervalls t₁ (dargestellt durch den Abstand zweier Punkte in 3c), bzw. Bildung des Mittelwerts 22 der gespeicherten Trafospannungswerte 6 der Sammelschiene innerhalb des Zeitintervalls t₂,
4) Bildung eines Differenzwerts 8, basierend auf dem gebildeten Mittelwert 7 und dem gemessenen Netzknotenspannungswert 5 bzw. Netzknotenspannungsmittelwert 19 an dem Netzknoten 4 und dem Sammelschienemittelwert 22,
5) Berechnung eines Netzknotenkorrespondenzwerts 20, welcher zumindest näherungsweise dem aktuell an dem Netzknoten 4 anliegenden Netzknotenspannungswert 5 entspricht, mit Hilfe des Differenzwerts 8 und des gebildeten Mittelwerts 7 und
6) laufendes Wiederholen der Schritte 2) bis 5), wobei bei Eintreffen eines weiteren an dem Netzknoten 4 anliegenden gemessenen Netzknotenspannungswerts 5 bzw. Netzknotenspannungsmittelwerts 19 mit diesem der Differenzwert 8 gebildet wird,
wobei eine Stufung des Transformatorstufenstellers durchgeführt wird, wenn der berechnete Netzknotenkorrespondenzwert 20 außerhalb eines vorgegebenen Spannungsbandes 9 liegt.

Somit ist es durch dieses Verfahren möglich, die zwischen den gemessenen Netzknotenspannungswerten 5 auftretenden Netzknotenspannungswerte 5 zu berechnen und eine Stufung des Transformatorstufenstellers erfolgt basierend auf dem aktuell berechneten Netzknotenkorrespondenzwert 20 in Abhängigkeit nachfolgender Prioritätsstufen:
1) der Netzknotenkorrespondenzwert 20 soll über einer Untergrenze des vorgegebenen Spannungsbandes 9 liegen und
2) der Netzknotenkorrespondenzwert 20 soll unter einer Obergrenze des vorgegebenen Spannungsbandes 9 liegen,
wobei die erste Prioritätsstufe erfüllt wird, bevor die zweite Prioritätsstufe betrachtet wird. Um die Genauigkeit der Berechnung des Netzknotenkorrespondenzwerts 20 zu erhöhen ist es sinnvoll den zeitlichen Verlauf der Trafospannungswerte 6 an der Sammelschiene über einen längeren Zeitraum mit einer hohen Granularität zu speichern. Dies ist auch notwendig, um einen Mittelwert 22 der Trafospannungswerte 6 über die Zeitdauer t₂ für die Bildung des Differenzwerts 8 zu ermöglichen.

Dabei wird bei der Übermittlung des Netzknotenspannungswerts 5 ein Zeitstempel zur Zuordnung des gemessenen Netzknotenspannungswerts 5 zu dem zeitlich zugehörigen gebildeten Mittelwert 7, 22 der gespeicherten Trafospannungswerte 6 mitgesendet, wodurch eine noch höhere Genauigkeit erzielt wird.

Dabei ist es in diesem Bespiel so, dass der Netzknotenspannungsmittelwert 19 aus gemessenen Netzknotenspannungswerten 5 innerhalb eines Zeitintervalls t₂ (siehe Fig. 3, 3a) gebildet und anstelle der gemessenen Netzknotenspannungswerte 5, vorzugsweise nach einer vorgegebenen Taktzeit t_{z} (in Fig. 3 ist zur Übermittlung der Netzknotenkorrespondenzwerte 20 keine fixe Taktzeit t_{z} vorgegeben), zur Weiterverarbeitung übermittelt wird. Besonders hier ist die Verwendung von Zeitstempeln wichtig, um die Netzknotenspannungsmittelwerte 19 korrekt zuordnen und berechnen zu können.

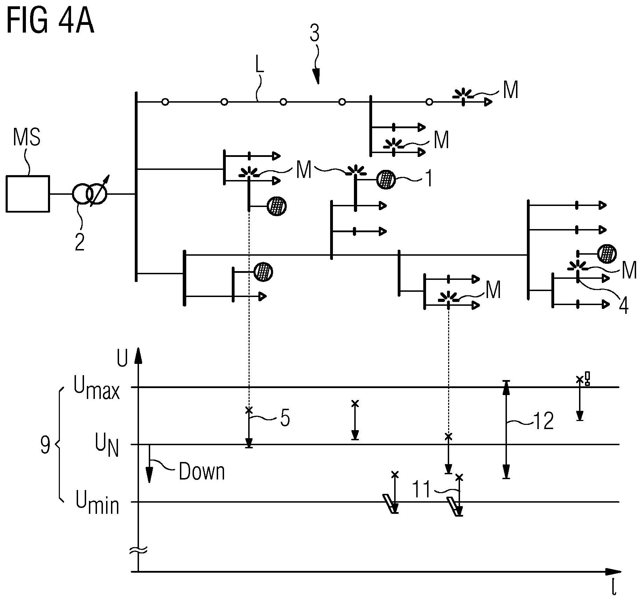

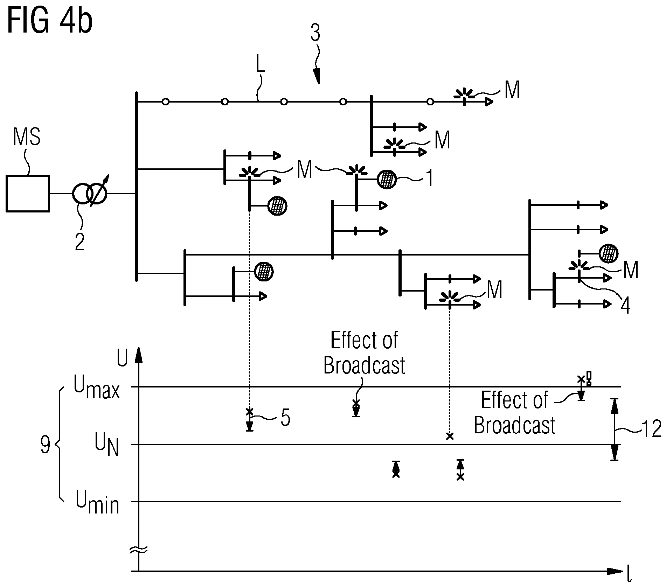

Fig. 4 zeigt eine weitere erfindungsgemäße Ausführungsform, bei der zusätzlich zur Stufung des Transformators 2 mittels einer geeigneten Kennlinie eine Energieerzeugungsanlage 1, beispielsweise in Form eines Wechselrichters, nachgeregelt wird. In Fig. 4a ist dabei die Verschiebung der Netzknotenspannungen 5 dargestellt, die sich durch alleinige Abstufung des Transformators 2 ergeben würden, in Fig. 4b die Verschiebung, die sich durch eine Änderung der Blindleistung Q ergibt. Vom Aufbau des Energieverteilnetzes 3 entspricht Fig. 4 der Fig. 2.

In Fig. 4a sieht man, dass der Netzknotenspannungswert 5 des am weitesten rechts liegenden Netzknotens 4 außerhalb des Spannungsbandes 9 liegt. Die Spreizung 12 zwischen höchstem und niedrigstem Netzknotenspannungswert 5 ist so hoch, dass durch ein Hinunterstufen des Transformators 2 (siehe linker Pfeil von U_{N} nach unten sowie Pfeile bei den einzelnen Netzknotenspannungswerten 5) zwar das Problem mit dem ganz rechten Netzknoten 4 beseitigt wird, aber andere Netzknoten 4 nach unten aus dem Spannungsband 9 wandern (durch Blitze markiert). Daher kann das Problem durch Hinunterstufen (allein) nicht gelöst werden, sondern es muss (zuvor) die Spreizung 12 verringert werden. Die Steuerung, welche nach dem erfindungsgemäßen Verfahren arbeitet, kann dies anhand der Netzknotenspannungswerte 5 erkennen und bereits vor Auftreten der Spannungsbandverletzung reagieren.

In Fig. 4b ist dargestellt, wie die Spreizung 12 durch die Beeinflussung einer Energieerzeugungsanlage 1 (oder natürlich auch mehrerer Energieerzeugungsanlagen 1) verringert werden kann. Dies wirkt sich je nach Netzsituation unterschiedlich stark bei den einzelnen Netzknoten 4 aus. In Fig. 4b sind die Netzknotenspannungswerte 5 wieder durch Kreuze dargestellt, deren Verschiebung durch die Beeinflussung der Energieerzeugungsanlage 1 ist wieder durch einen Pfeil kenntlich gemacht. Im Fall der Fig. 4b wird sogar das Problem der Verletzung der Spannungsgrenze 9 bereits durch die Beeinflussung der Energieerzeugungsanlage 1 behoben.

In weiterer Folge könnte erreicht werden, dass, wenn die Spreizung 12 einen Grenzwert unterschreitet, auch der Transformator 2 wieder stufen kann und so gegebenenfalls weitere auftretende Verletzungen des Spannungsbandes 9 beheben kann.

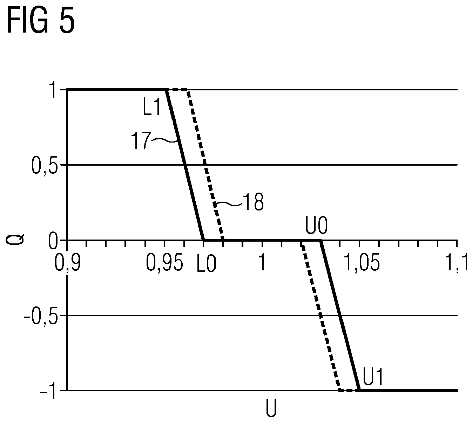

Um die optimale Verschiebung der Kennlinie zu finden, ist ein iteratives Verfahren vorgesehen, welches eine schrittweise Verstellung der Kennlinie vornimmt. Dabei kann jede beliebige Kennlinie, beispielsweise eine Spannungs-Wirk- und - Blindleistungs-Kennlinie 17 (P(U) und Q(U)-Kennlinie) (siehe Fig. 5) eingesetzt werden.

Die neuen Kennlinienpunkte werden per Broadcast an die Energieerzeugungsanlage 1 übermittelt, welche dementsprechend die Zufuhr der Blindleistung Q ändert. Zusätzlich wird durch Nachführen der aktuellen Kennlinie immer ein Abbild der aktiven Einstellungen der Energieerzeugungsanlage 1 erstellt. Dadurch wird sichergestellt, dass die implizierte Erkennung ungünstiger Betriebsweisen auch den geänderten Kennlinien folgt. Dazu können verschiedenste Parameter zur Nachführung dienen.

Vorteilhafterweise wird mit einem gemessenen maximalen Netzknotenspannungswert 10 und einem gemessenen minimalen Netzknotenspannungswert 11 (bzw. den entsprechenden berechneten Netzknotenkorrespondenzwerten 20) eine Spreizung 12 der Netzspannung des Energieverteilernetzes 3 berechnet (siehe Fig. 4). Diese berechnete Spreizung 12 wird im Anschluss an die Energieerzeugungsanlage 1 zur Abänderung einer einzuspeisenden Blindleistung Q übermittelt.

Dahingehend ist in Fig. 5 eine ursprüngliche Spannungs-Wirk-und Blindleistungs-Kennlinie 17 durchgehend dargestellt, während eine neu gebildete Spannungs-Wirk- und Blindleistungs-Kennlinie 18 strichliert dargestellt ist.

Dabei wird bei Überschreitung der Spreizung 12 (siehe Fig. 4) über einen vorgegebenen Maximalschwellwert schrittweise zusätzliche Blindleistung Q der Energieerzeugungsanlage 1 in das Energieverteilernetz 3 eingespeist und bei Unterschreitung der Spreizung 12 unter einen vorgegebenen Minimalschwellwert wird schrittweise weniger Blindleistung Q der Energieerzeugungsanlage 1 in das Energieverteilernetz 3 eingespeist (siehe Fig. 5), wobei zwischen zwei Schritten zumindest eine vorgegebene Intervalldauer t_{d} (nicht dargestellt) liegt. Dies dient dazu, ein ansonsten ohne einer vorgegebenen Intervalldauer t_{d} gegebenenfalls auftretendes schnelles Nachregeln durch die Steuerung zu vermeiden.

Durch die reduzierte Spreizung 12 können einerseits jene Netzknotenspannungswerte 5, welche außerhalb des Spannungsbandes 9 liegen, wieder in das Spannungsband 9 eingebracht werden (siehe Fig. 4b), andererseits kann der Stufensteller des Transformators 2 die Spannungsregelung unterstützen (in den Fig. nicht dargestellt).

Es wird somit bei Überschreitung der Spreizung 12 über den vorgegebenen Maximalschwellwert die Spannungs-Wirk- und Blindleistungs-Kennlinie 17 für eine Energieerzeugungsanlage 1 schrittweise enger gestellt (siehe Fig. 5, Strecke zwischen L0 und U0) und bei Unterschreitung der Spreizung 12 unter den vorgegebenen Minimalschwellwert die Spannungs-Wirk- und Blindleistungs-Kennlinie 17 für eine Energieerzeugungsanlage 1 schrittweise weiter gestellt, wobei die neu gebildete Spannungs-Wirk- und Blindleistungs-Kennlinie 18 an die Energieerzeugungsanlage 1 übertragen wird und es erfolgt solange eine schrittweise Anpassung der Spreizung 12 an die vorgegebenen Schwellwerte, bis die Spreizung 12 innerhalb der Schwellwerte liegt.

Somit sollte bei einer niedrigen Spreizung die Kennlinie so eingestellt werden, dass die Energieerzeugungsanlage 1 möglichst wenig Blindleistung Q einspeist, sodass Leitungsströme und in weiterer Folge Netzverluste klein gehalten werden.

Eine andere Möglichkeit als das Spannungsband der Kennlinie zu reduzieren, wie in Fig. 5 dargestellt, wäre beispielsweise eine vertikale Verschiebung der Kennlinie bei einem gleichbleibenden Spannungsband.

Des Weiteren ist vorgesehen, dass nach der Übertragung der neu gebildeten Spannungs-Wirk- und -Blindleistungs-Kennlinie 18 zumindest das Zeitintervall t₂ (siehe Fig. 3) zur Bildung des Netzknotenspannungsmittelwerts 19 abgewartet wird, bis eine weitere Spannungs-Wirk- und -Blindleistungs-Kennlinie 18 übertragen wird.

Durch die sich daraus ergebende Dezentralität und die weitgehende Unabhängigkeit vom Netzmodell wird ein sehr robustes Verfahren zur Vermeidung von Spannungsbandverletzungen erzielt. Es ist somit möglich sowohl flexibel auf unterschiedlich vorbehandelte Spannungsmessdaten aus dem Energieverteilernetz 3 zu reagieren als auch rasch größere Änderungen der Mittelspannung auszugleichen.

Um die Lebensdauer des Transformatorstufenstellers zu erhöhen, bietet sich darüber hinaus die Möglichkeit an, ein Verfahren basierend auf der inversen Zeitcharakteristik anzuwenden, wobei in Fig. 6 eine detaillierte Darstellung des zeitlichen Verlaufs eines an der Sammelschiene des Transformators 2 anliegenden Trafospannungswerts 6 dargestellt ist.

Dieses Verfahren führt eine Stufung des Transformatorstufenstellers aus, wenn ein aktuell anliegender Trafospannungswert 6 von einem vorgegebenen Spannungsband 9 in Abhängigkeit der Stufenhöhe des Transformators 2 abweicht.

In dem in Fig. 6 dargestellten erfindungsgemäßen Ausführungsbeispiel wird ab dem Zeitpunkt izₛ eine inverse Zeitcharakteristik durchgeführt, da zum Zeitpunkt izₛ der Trafospannungswert 6 die maximale Spannungsgrenze Uₘₐₓ überschreitet. Dabei wird eine Abweichung 15 des Trafospannungswerts 6 von dem vorgegebenen Spannungsband 9 solange mit einem Summenwert 21 summiert, bis eine vorgegebene Summenkonstante 16 erreicht wird, woraufhin eine Stufung des Transformatorstufenstellers durchgeführt und der Summenwert 21 auf Null zurückgesetzt wird. Falls der Trafospannungswert 6 zwischenzeitlich die maximale Spannungsgrenze Uₘₐₓ unterschreitet, so wird eine Pause izₚ der inversen Zeitcharakteristik durchgeführt, bis der Trafospannungswert 6 wieder die maximale Spannungsgrenze Uₘₐₓ überschreitet. Innerhalb der Pause izₚ wird der Summenwert 21 gemäß dem unteren Spannungsverlauf in Fig. 6 konstant gehalten. Falls der Trafospannungswert 6 die Nennspannung U_{N} unterschreitet, so erfolgt eine Rücksetzung iz_{R} der inversen Zeitcharakteristik bzw. des Summenwerts 21 auf Null (siehe senkrechten Pfeil zum Zeitpunkt iz_{R}). Ein Aufsummieren der Abweichung 15 auf den Summenwert 21 erfolgt solange, bis die vorgegebene Summenkonstante 16 erreicht ist. In dem Fig. 6 dargestellten Ausführungsbeispiel ist dies zum Zeitpunkt iz_{U} gegeben, woraufhin eine Stufung durchgeführt und der bis dato aufsummierte Summenwert 21 auf Null zurückgesetzt wird (siehe senkrechten Pfeil zum Zeitpunkt iz_{U}). Die Parameter dieser Regelung sind somit durch das Spannungsband 9 (gibt die minimale Spannungsgrenze Uₘᵢₙ und die maximale Spannungsgrenze Uₘₐₓ vor) und der Summenkonstante 16 (jener Wert, ab dem eine Stufung durchgeführt wird) vorgegeben.

Das beschriebene Verfahren zur Nutzung der inversen Zeitcharakteristik kann aber nicht nur auf Basis der Trafospannungswerte 6 durchgeführt werden, sondern wird in der Regel auf Basis der Netzknotenspannungswerte 5, vorzugsweise auf Basis der errechneten Netzknotenkorrespondenzwerte 20, eines Netzknotens 4 durchgeführt. Wenn mehrere Netzknoten 4 überwacht werden, so verfügt man über mehrere Verläufe von Netzknotenkorrespondenzwerten 20. Diese sind dann zueinander kongruente Kurven, die lediglich entlang der Spannungsachse U gegeneinander verschoben sind. In der Regel wählt man dann den Verlauf jenes Netzknotens für die inverse Zeitcharakteristik aus, der die höchste Spannung aufweist. Falls sowohl die minimale Uₘᵢₙ als auch die maximale Spannungsgrenze Uₘₐₓ durch den ausgewählten Spannungsverlauf verletzt werden, herrscht eine zu große Spreizung 12 vor und es muss vor der Stufung eine Verringerung der Spreizung 12 erfolgen.

### Bezugszeichenliste:

- 1: Energieerzeugungsanlage;
- 2: Transformator;
- 3: Energieverteilernetz;
- 4: Netzknoten;
- 5: Netzknotenspannungswert;
- 6: Trafospannungswert;
- 7: Mittelwert, gebildet durch die gespeicherten Trafospannungswerte 6 über die Zeit t₁;
- 8: Differenzwert;
- 9: Spannungsband;
- 10: maximaler Netzknotenspannungswert 5;
- 11: minimaler Netzknotenspannungswert 5;
- 12: Spreizung;
- 13: -;
- 14: -;
- 15: Abweichung der Spannungswerte 5,6;
- 16: Summenkonstante;
- 17: Spannungs-Wirk- und Blindleistungs-Kennlinie;
- 18: neu gebildete Spannungs-Wirk- und Blindleistungs-Kennlinie;
- 19: Netzknotenspannungsmittelwert;
- 20: Netzknotenkorrespondenzwert;
- 21: Summenwert;
- 22: Mittelwert, gebildet durch die gespeicherten Trafospannungswerte 6 über die Zeit t₂;

- izₛ: Start der inversen Zeitcharakteristik;
- izₚ: Pause der inversen Zeitcharakteristik;
- iz_{R}: Rücksetzen der inversen Zeitcharakteristik;
- iz_{U}: Stufung und Rücksetzen des Summenwerts 21 auf Null; l Stranglänge;
- L: Versorgungsleitungen;
- MS: Mittelspannung;
- M: Messeinrichtungen;
- P: Wirkleistung;

- Q: Blindleistung;
- t_{d}: Intervalldauer;
- t₁: Zeitintervall zur Bildung des Mittelwerts 7;
- t₂: Zeitintervall zur Bildung des Netzknotenspannungsmittelwerts 19;
- t_{z}: Taktzeit, nach welcher der Netzknotenspannungsmittelwert 19 übermittelt wird;
- Tᵣ: Trichter;
- U: Spannung;
- Uₘᵢₙ: minimale Spannungsgrenze;
- Uₘₐₓ: maximale Spannungsgrenze; und
- U_{N}: Nennspannung.

## Patentansprüche

1. Verfahren zur Vermeidung von Spannungsbandverletzungen zumindest eines Abschnitts eines Energieverteilernetzes (3), welches zumindest einen Transformator (2) mit einem Transformatorstufensteller und einer Sammelschiene sowie zumindest einen Netzknoten (4) umfasst, **gekennzeichnet durch** die folgenden Schritte:
1) laufende Messung zumindest eines Netzknotenspannungswerts (5) an dem Netzknoten (4),
2) laufende Messung und Speicherung von Trafospannungswerten (6) an der Sammelschiene,
3) Bildung zumindest eines Mittelwerts (7, 22) der gespeicherten Trafospannungswerte (6) der Sammelschiene, vorzugsweise innerhalb eines vorgegebenen Zeitintervalls (t₁, t₂),
4) Bildung eines Differenzwerts (8), basierend auf einem gebildeten Mittelwert (22) und dem gemessenen Netzknotenspannungswert (5) an dem Netzknoten (4),
5) Berechnung eines Netzknotenkorrespondenzwerts (20), welcher zumindest näherungsweise dem aktuell an dem Netzknoten (4) anliegenden Netzknotenspannungswert (5) entspricht, mit Hilfe des Differenzwerts (8) und eines gebildeten Mittelwerts (7) und
6) laufendes Wiederholen der Schritte 2) bis 5), wobei bei Eintreffen eines weiteren an dem Netzknoten (4) anliegenden gemessenen Netzknotenspannungswerts (5) mit diesem der Differenzwert (8) gebildet wird,
wobei eine Stufung des Transformatorstufenstellers durchgeführt wird, wenn der berechnete Netzknotenkorrespondenzwert (20) außerhalb eines vorgegebenen Spannungsbandes (9) liegt.

2. Verfahren nach Anspruch 1, **dadurch gekennzeichnet, dass** eine Stufung des Transformatorstufenstellers basierend auf dem aktuell berechneten Netzknotenkorrespondenzwert (20) in Abhängigkeit nachfolgender Prioritätsstufen erfolgt:
1) der Netzknotenkorrespondenzwert (20) soll über einer Untergrenze des vorgegebenen Spannungsbandes (9) liegen und
2) der Netzknotenkorrespondenzwert (20) soll unter einer Obergrenze des vorgegebenen Spannungsbandes (9) liegen, wobei die erste Prioritätsstufe erfüllt wird, bevor die zweite Prioritätsstufe betrachtet wird.

3. Verfahren nach Anspruch 1 oder 2, **dadurch gekennzeichnet, dass** bei der Übermittlung des Netzknotenspannungswerts (5) ein Zeitstempel zur Zuordnung des gemessenen Netzknotenspannungswerts (5) zu dem zeitlich zugehörigen gebildeten Mittelwert (7, 22) der gespeicherten Trafospannungswerte (6) mitgesendet wird.

4. Verfahren nach einem der Ansprüche 1 bis 3, **dadurch gekennzeichnet, dass** ein Netzknotenspannungsmittelwert (19) aus gemessenen Netzknotenspannungswerten (5) innerhalb eines Zeitintervalls (t₂) gebildet und anstelle der gemessenen Netzknotenspannungswerte (5), vorzugsweise nach einer vorgegebenen Taktzeit (t_{z}), zur Weiterverarbeitung übermittelt wird.

5. Verfahren nach Anspruch 4, **dadurch gekennzeichnet, dass** zur Bildung des Differenzwerts (8) ein Mittelwert (22) der gespeicherten Trafospannungswerte (6) herangezogen wird, der innerhalb des gleichen Zeitintervalls (t₂) wie der Netzknotenspannungsmittelwert (19) gebildet wird, während für die Berechnung des Netzknotenkorrespondenzwerts (20) ein anderer Mittelwert (7) der gespeicherten Trafospannungswerte (6) herangezogen wird, der während eines kürzeren Zeitintervalls (t₁) gebildet wird.

6. Verfahren nach einem der Ansprüche 1 bis 5, **dadurch gekennzeichnet, dass** mit einem gemessenen maximalen Netzknotenspannungswert (10) und einem gemessenen minimalen Netzknotenspannungswert (11), oder entsprechenden berechneten Netzknotenkorrespondenzwerten (20), eine Spreizung (12) der Netzspannung des Energieverteilernetzes (3), an welches ferner zumindest eine Energieerzeugungsanlage (1) angeschlossen ist, berechnet wird, welche Spreizung (12) an die Energieerzeugungsanlage (1) zur Abänderung einer einzuspeisenden Blindleistung (Q) übermittelt wird.

7. Verfahren nach Anspruch 6, **dadurch gekennzeichnet, dass** bei Überschreitung der Spreizung (12) über einen vorgegebenen Maximalschwellwert schrittweise zusätzliche Blindleistung (Q) einer Energieerzeugungsanlage (1) in das Energieverteilernetz (3) eingespeist wird und bei Unterschreitung der Spreizung (12) unter einen vorgegebenen Minimalschwellwert schrittweise weniger Blindleistung (Q) einer Energieerzeugungsanlage (1) in das Energieverteilernetz (3) eingespeist wird,
wobei zwischen zwei Schritten zumindest eine vorgegebene Intervalldauer (t_{d}) liegt.

8. Verfahren nach Anspruch 6, **dadurch gekennzeichnet, dass** bei Überschreitung der Spreizung (12) über den vorgegebenen Maximalschwellwert eine Spannungs-Wirk- und Blindleistungs-Kennlinie (17) für eine Energieerzeugungsanlage (1) schrittweise enger gestellt wird und
bei Unterschreitung der Spreizung (12) unter den vorgegebenen Minimalschwellwert die Spannungs-Wirk- und - Blindleistungs-Kennlinie (17) für die Energieerzeugungsanlage (1) schrittweise weiter gestellt wird,
wobei eine neu gebildete Spannungs-Wirk- und -Blindleistungs-Kennlinie (18) an die Energieerzeugungsanlage (1) übertragen wird und solange eine schrittweise Anpassung der Spreizung (12) an die vorgegebenen Schwellwerte erfolgt, bis die Spreizung (12) innerhalb der Schwellwerte liegt.

9. Verfahren nach Anspruch 4 und 8, **dadurch gekennzeichnet, dass** nach der Übertragung der neu gebildeten Spannungs-Wirk- und -Blindleistungs-Kennlinie (18) zumindest das Zeitintervall (t₂) zur Bildung des Netzknotenspannungsmittelwerts (19) abgewartet wird, bis eine weitere Spannungs-Wirk- und -Blindleistungs-Kennlinie (18) übertragen wird.

10. Verfahren nach einem der Ansprüche 1 bis 9, **dadurch gekennzeichnet, dass** eine Abweichung (15) des Spannungswerts (5,6, 20) von einem vorgegebenen Spannungsband (9) solange mit einem Summenwert (21) summiert wird, bis eine vorgegebene Summenkonstante (16) erreicht wird, woraufhin eine Stufung des Transformatorstufenstellers durchgeführt und der Summenwert (21) auf Null zurückgesetzt wird.

11. Computerprogrammprodukt, welches ein Programm umfasst und direkt in einen Speicher eines zentralen Rechners eines Energieverteilernetzes (3) ladbar ist, mit Programm-Mitteln, um alle Schritte des Verfahrens nach einem der Ansprüche 1 bis 10 auszuführen, wenn das Programm vom zentralen Rechner ausgeführt wird.

## Claims

1. Method for preventing voltage range deviations of at least one section of a power distribution network (3) which comprises at least one transformer (2) with a transformer tap changer and a busbar, and at least one network node (4), **characterised by** the following steps:
1) continuous measurement of at least one network node voltage value (5) at the network node (4),
2) continuous measurement and storage of transformer voltage values (6) at the busbar,
3) generation of at least one mean value (7, 22) of the stored transformer voltage values (6) of the busbar, preferably within a predetermined time interval (t₁, t₂),
4) generation of a difference value (8) based on a generated mean value (22) and the measured network node voltage value (5) at the network node (4),
5) calculation of a network node correspondence value (20) which corresponds at least approximately to the network node voltage value (5) currently present at the network node (4), with the aid of the difference value (8) and a generated mean value (7), and
6) continuous repetition of steps 2) to 5), wherein on arrival of a further measured network node voltage value (5) present at the network node (4), this is used to form the difference value (8),
wherein tap changing of the transformer tap changer is performed if the calculated network node correspondence value (20) lies outside a predetermined voltage range (9).

2. Method according to claim 1, **characterised in that** tap changing of the transformer tap changer takes place based on the currently calculated node correspondence value (20) as a function of the following priority levels:
1) the network node correspondence value (20) should be above a lower limit of the predetermined voltage range (9) and
2) the network node correspondence value (20) should be below an upper limit of the predetermined voltage range (9), wherein the first priority level is met before the second priority level is considered.

3. Method according to claim 1 or 2, **characterised in that** during the transmission of the network node voltage value (5) a time stamp for assigning the measured network node voltage value (5) to the temporally associated generated mean value (7, 22) of the stored transformer voltage values (6) is sent at the same time.

4. Method according to one of claims 1 to 3, **characterised in that** a network node mean voltage value (19) is generated from measured network node voltage values (5) within a time interval (t₂) and is transmitted for further processing instead of the measured network node voltage values (5), preferably after a predetermined cycle time (t_{z}).

5. Method according to claim 4, **characterised in that** for the generation of the difference value (8) a mean value (22) of the stored transformer voltage values (6) is used, which is generated within the same time interval (t₂) as the network node mean voltage value (19), while for the calculation of the network node correspondence value (20) another mean value (7) of the stored transformer voltage values (6) is used, which is generated during a shorter time interval (tᵢ).

6. Method according to one of claims 1 to 5, **characterised in that** using a measured maximum network node voltage value (10) and a measured minimum network node voltage value (11), or corresponding calculated network node correspondence values (20), a spread (12) of the network voltage of the power distribution network (3), to which further at least one power generation plant (1) is connected, is calculated, said spread (12) being transmitted to the power generation plant (1) to modify a reactive power (Q) to be fed in.

7. Method according to claim 6, **characterised in that** when the spread (12) exceeds a predetermined maximum threshold, progressively more reactive power (Q) of a power generation plant (1) is fed into the power distribution network (3) and when the spread (12) drops below a predetermined minimum threshold progressively less reactive power (Q) of a power generation plant (1) is fed into the power distribution network (3),
wherein there is at least one predetermined interval duration (t_{d}) between two steps.

8. Method according to claim 6, **characterised in that** when the spread (12) exceeds the predetermined maximum threshold a voltage active and reactive power characteristic curve (17) for a power generation plant (1) is made progressively narrower and
when the spread (12) drops below the predetermined minimum threshold the voltage active and reactive power characteristic curve (17) for the power generation plant (1) is made progressively wider,
wherein a newly generated voltage active and reactive power characteristic curve (18) is transmitted to the power generation plant (1) and
a progressive adjustment of the spread (12) to the predetermined thresholds is performed until the spread (12) lies within the thresholds.

9. Method according to claim 4 and 8, **characterised in that** after the transfer of the newly generated voltage active and reactive power characteristic curve (18) there is a wait for at least the time interval (t₂) for the generation of the network node voltage mean value (19) until a further voltage active and reactive power characteristic curve (18) is transmitted.

10. Method according to one of claims 1 to 9, **characterised in that** a deviation (15) of the voltage value (5, 6, 20) from a predetermined voltage range (9) is summed with a summation value (21) until a predetermined summation constant (16) is reached, whereupon tap changing of the transformer tap changer is performed and the summation value (21) is reset to zero.

11. Computer program product which comprises a program and can be loaded directly into a memory of a central processor of a power distribution network (3), having program means to execute all steps of the method according to one of claims 1 to 10 when the program is executed by the central processor.

## Revendications

1. Procédé permettant d'éviter des violations de plages de tension d'au moins un tronçon d'un réseau de distribution d'énergie (3) qui comprend au moins un transformateur (2) comportant un régulateur de niveau de transformateur et une barre omnibus ainsi qu'au moins un noeud de réseau (4), **caractérisé par** les étapes suivantes :
1) mesure continue d'au moins une valeur de tension de noeud de réseau (5) au niveau du noeud de réseau (4) ;
2) mesure continue et sauvegarde de valeurs de tension de transformateur (6) sur la barre omnibus ;
3) formation d'au moins une valeur moyenne (7, 22) des valeurs de tension de transformateur sauvegardées (6) de la barre omnibus, de préférence dans un intervalle de temps donné (t₁, t₂),
4) formation d'une valeur différentielle(8) sur la base d'une valeur moyenne formée (22) et de la valeur de tension de noeud de réseau mesurée (5) au niveau du noeud de réseau (4),
5) calcul d'une valeur de correspondance de noeud de réseau (20), qui correspond au moins approximativement à la valeur de tension de noeud de réseau (5) actuellement appliquée au noeud de réseau (4), à l'aide de la valeur différentielle (8) et d'une valeur moyenne formée (7) et
6) répétition continue des étapes 2) à 5), à l'arrivée d'une autre valeur de tension de noeud de réseau (5) mesurée appliquée au noeud de réseau (4) étant formée avec celle-ci la valeur différentielle (8),
une gradation du régulateur de niveau de transformateur étant effectuée lorsque la valeur de correspondance de noeud de réseau calculée (20) se trouve en dehors d'une plage de tension donnée (9).

2. Procédé selon la revendication 1, **caractérisé en ce qu'**une gradation du régulateur de niveau de transformateur a lieu sur la base de la valeur de correspondance de noeud de réseau calculée actuelle (20) en fonction des niveaux de priorité suivantes :
1) la valeur de correspondance de noeud de réseau (20) doit se trouver au-dessus d'une limite inférieure de la plage de tension donnée (9) et
2) la valeur de correspondance de noeud de réseau (20) doit se trouver en dessous d'une limite supérieure de la plage de tension donnée (9), le premier niveau de priorité étant rempli avant que le deuxième niveau de priorité soit envisagé.

3. Procédé selon la revendication 1 ou 2, **caractérisé en ce que**, lors de la transmission de la valeur de tension de noeud de réseau (5), un horodateur est envoyé avec pour associer la valeur de tension de noeud de réseau mesurée (5) à la valeur moyenne formée associée temporellement (7, 22) des valeurs de tension de transformateur sauvegardées (6).

4. Procédé selon l'une des revendications 1 à 3, **caractérisé en ce qu'**une valeur moyenne de tension de noeud de réseau (19) est formée à partir de valeurs de tension de noeud de réseau mesurées (5) dans un intervalle de temps (t₂) et est transmise pour traitement subséquent au lieu des valeurs de tension de noeud de réseau mesurées (5), de préférence après une durée de cycle donnée (t_{z}).

5. Procédé selon la revendication 4, **caractérisé en ce que**, pour former la valeur différentielle (8), une valeur moyenne (22) des valeurs de tension de transformateur (6) sauvegardées est utilisée, laquelle est formée dans le même intervalle de temps (t₂) que la valeur moyenne de tension de noeud de réseau (19), tandis que, pour le calcul de la valeur de correspondance de noeud de réseau (20), une autre valeur moyenne (7) des valeurs de tension de transformateur sauvegardées (6) est utilisée, laquelle est formée pendant un intervalle de temps plus court (t₁).

6. Procédé selon l'une des revendications 1 à 5, **caractérisé en ce qu'**est calculé, avec une valeur de tension de noeud de réseau maximale mesurée (10) et une valeur de tension de noeud de réseau minimale mesurée (11), ou des valeurs de correspondance de noeud de réseau calculées correspondantes (20), un étalement (12) de la tension de réseau du réseau de distribution d'énergie (3), auquel est en outre raccordée au moins une installation de production d'énergie (1), lequel étalement (12) est transmis à l'installation de production d'énergie (1) pour modifier une puissance réactive (Q) à injecter.

7. Procédé selon la revendication 6, **caractérisé en ce que**, si l'étalement (12) va au-delà d'une valeur seuil maximale donnée, plus de puissance réactive supplémentaire (Q) d'une installation de production d'énergie (1) est injectée progressivement dans le réseau de distribution d'énergie (3), et, si l'étalement (12) tombe en dessous d'une valeur seuil minimale donnée, moins de puissance réactive (Q) d'une installation de production d'énergie (1) est injectée progressivement dans le réseau de distribution d'énergie (3), entre les deux étapes se trouvant au moins une durée d'intervalle donnée (t_{d}).

8. Procédé selon la revendication 6, **caractérisé en ce que**, si l'étalement (12) dépasse la valeur seuil maximale donnée, une courbe caractéristique de puissance active de tension et de puissance réactive (17) pour une installation de production d'énergie (1) est rétrécie progressivement et, si l'étalement (12) tombe en dessous de la valeur seuil minimale donnée, la courbe caractéristique de puissance active de tension et de puissance réactive (17) pour l'installation de production d'énergie (1) est élargie progressivement, une courbe caractéristique de puissance active de tension et de puissance réactive (18) nouvellement formée étant transmise à l'installation de production d'énergie (1) et, tant qu'a lieu une adaptation progressive de l'étalement (12) aux valeurs seuils données, jusqu'à ce que l'étalement (12) se trouve dans les limites des valeurs seuils.

9. Procédé selon la revendication 4 et 8, **caractérisé en ce que**, après la transmission de la courbe caractéristique de puissance active de tension et de puissance réactive (18) nouvellement formée, on attend au moins l'intervalle de temps (t₂) pour former la valeur moyenne de tension de noeud de réseau (19) jusqu'à la transmission d'une autre courbe caractéristique de puissance active de tension et de puissance réactive (18).

10. Procédé selon l'une des revendications 1 à 9, **caractérisé en ce qu'**on additionne un écart (15) de la valeur de tension (5,6, 20) par rapport à une plage de tension donnée (9) et une valeur de somme (21) jusqu'à obtention d'une constante de somme donnée (16), suite à quoi une gradation du régulateur de niveau de transformateur est effectuée et la valeur de somme (21) est remise à zéro.

11. Produit de programme informatique qui comprend un programme et peut être chargé directement dans une mémoire d'un ordinateur central d'un réseau de distribution d'énergie (3), comprenant des moyens de programme pour exécuter toutes les étapes du procédé selon l'une des revendications 1 à 10 lorsque le programme est exécuté par l'ordinateur central.
